# FASCICULE DE BREVET EUROPEEN

(11) **EP 1 521 513 B1**
(45) Date de publication et mention de la délivrance du brevet: **09.12.2009**
(21) Numéro de dépôt: 04292286.4
(22) Date de dépôt: 23.09.2004
(51) Int. Cl.: H05K 7/14, F25B 9/02, F25D 19/00, H01L 23/44

(54) **Dispositif de support d'un détecteur**
Trägervorrichtung für einen Sensor
Supporting device for a sensor

(30) Priorité: 01.10.2003 FR 0311486
(43) Date de publication de la demande: 06.04.2005
(73) Titulaire: Sagem Défense Sécurité, 75015 Paris (FR)
(72) Inventeur: Coursaget, Francois, 78150 Le Chesnay (FR)
(74) Mandataire: Lavialle, Bruno François Stéphane

(56) Documents cités:
- EP-A- 0 493 208
- US-A- 5 382 797

## Description

La présente invention concerne un dispositif de refroidissement d'un détecteur.

Le dispositif de refroidissement est plus particulièrement destiné à être associé à un détecteur thermique infrarouge ou quantique utilisé dans les autodirecteurs de missiles.

### ARRIERE PLAN DE L'INVENTION

Ces détecteurs sont généralement des détecteurs à semi-conducteurs qui doivent être maintenus à une température de 80°K à 100°K pour fonctionner de manière optimale.

Pour cette raison, de tels détecteurs sont en général associé à un dispositif de refroidissement.

Le dispositif de refroidissement du détecteur comprend généralement un corps creux ayant une extrémité fermée par une cloison d'extrémité sur une face extérieure de laquelle le détecteur est fixé. Le corps creux contient un conduit d'amenée d'un fluide de refroidissement au voisinage de la cloison d'extrémité du corps creux et un conduit d'évacuation du fluide de refroidissement débouchant au voisinage de la cloison d'extrémité du corps creux.

Le fluide de refroidissement provient d'une machine frigorifique.

Pour les missiles dont la durée de vol est relativement courte, le refroidissement met en oeuvre la détente de Joule-Thomson.

Sur le pas de tir, le conduit d'amenée du fluide de refroidissement est raccordé à un réservoir fixe contenant un gaz sous pression. Immédiatement avant le lancement du missile, le gaz sous pression est admis dans l'extrémité fermée du corps creux via le conduit d'amenée qui a une forme de serpentin et qui se termine par un gicleur. A la sortie du gicleur, il se produit une détente isentropique du gaz qui en contact avec la cloison d'extrémité du corps creux provoque le refroidissement de la cloison d'extrémité. Le conduit d'évacuation fait s'écouler le gaz détendu le long du conduit d'amenée. Le gaz détendu refroidit le conduit d'amenée jusqu'à obtenir une liquéfaction du gaz à la sortie du gicleur. A l'équilibre des phases liquide et gazeuse en sortie du gicleur, la température minimale est atteinte. Le réservoir de gaz sous pression est ensuite physiquement coupé du conduit d'amenée afin de permettre le lancement du missile.

Ce système permet un refroidissement particulièrement rapide. Toutefois, dans le cas d'un missile sol-air qui s'étend généralement verticalement, le gaz s'échappe trop vite et le refroidissement est moins bon.

### OBJET DE L'INVENTION

Un but de l'invention est de fournir un moyen permettant un refroidissement efficace et prolongé du détecteur.

### BREVE DESCRIPTION DE L'INVENTION

A cet effet, on prévoit, selon l'invention, un dispositif de refroidissement tel que défini dans la revendication 1.

Ainsi, une partie du fluide de refroidissement est retenue dans le réservoir dont la paroi fixée au corps creux permet un échange thermique entre le fluide de refroidissement et le corps creux. Le refroidissement de la cloison d'extrémité et du détecteur qui y est fixé est alors particulièrement efficace.

De préférence, le réservoir a une paroi latérale externe qui est formée d'une portion de paroi latérale du corps creux voisine de la cloison d'extrémité.

Ainsi, l'échange thermique entre le réservoir et l'extrémité fermée est amélioré.

Avantageusement, la paroi fixée au corps creux a une forme cylindrique et constitue une paroi latérale interne du réservoir.

Le réservoir a alors une forme annulaire permettant d'avoir une surface d'échange relativement importante et facilitant son implantation dans le corps creux.

D'autres caractéristiques et avantages de l'invention ressortiront à la lecture de la description qui suit d'un mode de réalisation particulier non limitatif de l'invention.

### BREVE DESCRIPTION DES DESSINS

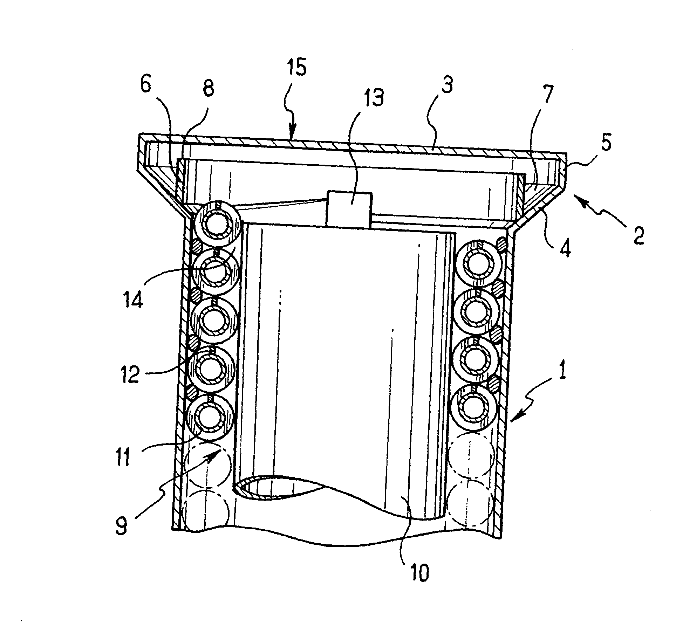

Il sera fait référence à la figure unique annexée, représentant en coupe longitudinale un dispositif de refroidissement conforme à l'invention.

### DESCRIPTION DETAILLEE DE L'INVENTION

Le dispositif de refroidissement conforme à l'invention et ici décrit est destiné à être disposé dans l'ogive d'un missile pour supporter un détecteur qui doit être refroidi. Le détecteur est par exemple un détecteur infrarouge à semi-conducteur destiné à recueillir des images infrarouges exploitées par l'autodirecteur du missile.

Le dispositif de refroidissement selon l'invention comprend un corps creux généralement désigné en 1 ayant une extrémité généralement désigné en 2 fermée par une cloison d'extrémité 3 s'étendant transversalement au corps creux 1. Le détecteur est destiné à être fixée sur une face externe 15 de la cloison d'extrémité 3.

L'extrémité 2 est ici évasée et comprend une paroi tronconique 4 ayant une extrémité de petite section reliée à une partie centrale du corps creux 1 et une extrémité de grande section à laquelle est fixée une paroi cylindrique 5 dont est solidaire la cloison d'extrémité 3.

Une paroi cylindrique 6 s'étend axialement dans l'extrémité 2 depuis la paroi tronconique 4 au voisinage de son extrémité de petite section pour délimiter avec la paroi tronconique 4 et la paroi cylindrique 5 un réservoir 7 de forme annulaire. Le bord libre 8 de la paroi cylindrique 6 est espacé de la cloison d'extrémité 3 et délimite une ouverture du réservoir 7.

Le corps creux 1 reçoit une sonde Joule-Thomson connue en elle-même et généralement désignée en 9. La sonde de Joule-Thomson 9 comprend un tube support 10 s'étendant coaxialement à l'intérieur du corps creux 1.

Un conduit d'amenée 11 d'un fluide de refroidissement s'enroule autour du tube support 10. Le conduit d'amenée 11 a une forme de serpentin autour duquel une aile 12 s'étend en hélice. Le conduit d'amenée 11 se termine par un gicleur 13 situé au voisinage de la cloison d'extrémité 3 et orienté vers la cloison d'extrémité 3 pour projeter le fluide de refroidissement vers celle-ci. Le conduit d'amenée 11 comporte à l'opposé du gicleur 13 une extrémité non représentée qui débouche à l'extérieur de l'ogive pour être connectée à un réservoir de gaz neutre sous pression destiné à former le fluide de refroidissement.

Un conduit d'évacuation 14 du fluide refroidissement est délimité par le corps creux 1 et le tube support 10. On remarque que le conduit d'amenée 11 s'étend dans le conduit d'évacuation 14 ainsi formé. L'aile 12 en hélice maintient espacées les différentes spires du conduit d'amenée 11 pour permettre le passage du fluide de refroidissement entre celles-ci.

Les extrémités inférieures du corps creux 1, du conduit d'amenée 11 et du conduit d'évacuation 14 sont connues en elles-mêmes et ne sont pas représentées ici.

Le fonctionnement du dispositif va maintenant être décrit.

Immédiatement avant le lancement du missile, le gaz neutre contenu dans le réservoir fixe est introduit sous pression dans le conduit d'amenée 11. A la sortie du gicleur 13, le gaz neutre remplit l'extrémité 2 où il se dilate et se refroidit exerçant sa fonction de fluide de refroidissement de la cloison d'extrémité 3.

Une partie du gaz est projetée dans le réservoir 7 par l'ouverture de celui-ci. Cette partie du gaz retenue dans le réservoir 7 favorise le refroidissement de la cloison d'extrémité 3.

L'autre partie du gaz s'écoule dans le conduit d'évacuation 14 et refroidit le conduit d'amenée 11. L'amenée de gaz se poursuivant, le refroidissement augmente jusqu'à ce que le gaz se liquéfie à la sortie du gicleur 13.

A l'équilibre entre les phases liquide et gazeuse, le fluide de refroidissement a alors une température optimale. Une partie du fluide de refroidissement est retenue dans le réservoir 7.

Au moment du lancement, le conduit d'amenée 11 est coupé du réservoir fixe.

Tandis que le missile se dirige vers sa cible, le refroidissement de la cloison d'extrémité 3 est assuré en partie par le fluide de refroidissement retenu dans le réservoir 7.

Bien entendu, l'invention n'est pas limitée au mode de réalisation décrit et on peut y apporter des variantes de réalisation sans sortir du cadre de l'invention tel que défini par les revendications.

En particulier, bien que le corps creux 1 ait été illustré sous forme d'un corps tubulaire cylindrique sur la majeure partie de sa hauteur, il peut comporter une cavité interne de forme quelconque, par exemple conique.

Le réservoir 7 peut avoir d'autres formes ou être réalisé différemment. Le réservoir peut ainsi être fixé à la cloison d'extrémité 3. Le réservoir peut par exemple être rapporté en totalité dans le corps creux. On veillera alors à ce que la liaison du réservoir au corps creux permette un échange thermique suffisant. Le réservoir peut par exemple avoir en coupe transversale une section en U ou en J.

## Revendications

1. Dispositif de refroidissement d'un détecteur fixé sur une face extérieure (15) d'une cloison d'extrémité (3) d'un corps creux (1) contenant un conduit d'amenée de fluide de refroidissement (11) s'étendant à l'intérieur du corps creux (1) et se terminant par un gicleur (13) au voisinage de la cloison d'extremité (3), et contenant de plus un conduit d'évacuation du fluide de refroidissement (14) débouchant au voisinage de la cloison d'extrémité, **caractérisé en ce que** le dispositif comprend un réservoir (7) délimité par au moins une paroi (6) fixée au corps creux et ayant un bord (8) définissant une ouverture adjacente à la cloison d'extrémité afin de retenir au moyen de ladite ouverture une partie du fluide de refroidissement entre sa sortie du gicleur et son évacuation par ledit conduit.

2. Dispositif selon la revendication 1, **caractérisé en ce que** le réservoir (7) a une paroi latérale externe qui est formée d'une portion de paroi latérale (4, 5) du corps creux (1) voisine de la cloison d'extrémité (3).

3. Dispositif selon la revendication 1 ou la revendication 2, **caractérisé en ce que** la paroi (6) fixée au corps creux a une forme cylindrique et constitue une paroi latérale interne du réservoir.

4. Dispositif selon la revendication 3, **caractérisé en ce que** le corps creux (1) comporte une portion évasée (2) au voisinage de la cloison d'extrémité (3), et **en ce que** la paroi latérale interne (6) s'étend axialement dans la portion évasée de l'extrémité fermée.

## Claims

1. A cooling device for cooling a detector fastened on an outside face (15) of an end partition (3) of a hollow body (1) containing a feed duct (11) for feeding a cooling fluid, the feed duct extending inside the hollow body (1) and terminating in a nozzle (13) in the vicinity of the end partition (3), and also containing a cooling-fluid exhaust duct (14) opening out in the vicinity of the end partition, the device being **characterized in that** it includes a reservoir (7) defined by at least one wall (6) fastened to the hollow body and having an edge (8) defining an opening adjacent to the end partition so as to act via said opening to retain a fraction of the cooling fluid between leaving the nozzle and being exhausted via said duct.

2. A device according to claim 1, **characterized in that** the reservoir (7) has an outer side wall that is formed by a portion of the side wall (4, 5) of the hollow body (1) in the vicinity of the end partition (3).

3. A device according to claim 1 or claim 2, **characterized in that** the wall (6) fastened to the hollow body is cylindrical in shape and constitutes an inner side wall of the reservoir.

4. A device according to claim 3, **characterized in that** the hollow body (1) includes a flared portion (2) in the vicinity of the end partition (3), and **in that** the inner side wall (6) extends axially into the flared portion of the closed end.

## Patentansprüche

1. Kühlvorrichtung zum Kühlen eines Detektors, der auf einer Außenfläche (15) einer Endwand (3) eines Hohlkörpers (1) befestigt ist, der eine Kühlfluid-Zuführleitung (11) enthält, die sich im Inneren des Hohlkörpers (1) erstreckt und in der Nähe der Endwand (3) mit einer Düse (13) abschließt, und ferner eine Kühlfluid-Abführleitung (14) enthält, die in der Nähe der Endwand mündet, **dadurch gekennzeichnet, dass** die Vorrichtung ein Reservoir (7) umfasst, das von mindestens einer Wand (6) begrenzt ist, die am Hohlkörper befestigt ist und einen Rand (8) hat, der eine an die Endwand angrenzende Öffnung festlegt, um mittels der genannten Öffnung einen Teil des Kühlfluids zwischen dessen Austritt aus der Düse und dessen Abführung durch die genannte Leitung zurückzuhalten.

2. Vorrichtung nach Anspruch 1, **dadurch gekennzeichnet, dass** das Reservoir (7) eine äußere Seitenwand hat, die aus einem Abschnitt (4, 5) der Seitenwand des Hohlkörpers (1) nahe der Endwand (3) gebildet ist.

3. Vorrichtung nach Anspruch 1 oder Anspruch 2, **dadurch gekennzeichnet, dass** die Wand (6), die an dem Hohlkörper befestigt ist, eine zylindrische Form hat und eine innere Seitenwand des Reservoirs bildet.

4. Vorrichtung nach Anspruch 3, **dadurch gekennzeichnet, dass** der Hohlkörper (1) nahe der Endwand (3) einen aufgeweiteten Abschnitt (2) hat und dass sich die innere Seitenwand (6) axial in dem aufgeweiteten Abschnitt des geschlossenen Endes erstreckt.
